# EUROPEAN PATENT SPECIFICATION

(11) **EP 3 624 285 B1**
(45) Date of publication and mention of the grant of the patent: **01.06.2022**
(21) Application number: 18194482.8
(22) Date of filing: 14.09.2018
(51) Int. Cl.: H02G 3/10, H05K 5/00, F24F 11/89

(54) **WALL-MOUNTABLE BACK PLATE FOR SECURING A CONTROL MODULE TO A WALL, AND ASSEMBLY COMPRISING SUCH A BACK PLATE**
WANDMONTIERBARE RÜCKPLATTE ZUR BEFESTIGUNG EINES STEUERUNGSMODULS AN EINER WAND, SOWIE BAUEINHEIT MIT EINER SOLCHEN RÜCKPLATTE
PLAQUE ARRIÈRE POUVANT ÊTRE MONTÉE SUR UN MUR POUR FIXER UN MODULE DE COMMANDE À UNE PAROI, ET ASSEMBLAGE COMPRENANT UNE TELLE PLAQUE ARRIÈRE

(43) Date of publication of application: 18.03.2020
(73) Proprietor: Ademco Inc., Golden Valley, MN 55422 (US)
(72) Inventor: KYNOCH, David, Morris Plains, NJ New Jersey 07950 (US); DOLEZALOVA, Petra, Morris Plains, NJ New Jersey 07950 (US); CURRIE, Edward, Morris Plains, NJ New Jersey 07950 (US)
(74) Representative: Murgitroyd & Company

(56) References cited:
- US-A- 5 729 442
- US-A1- 2008 013 259
- US-A1- 2014 226 286
- US-A1- 2015 327 375

## Description

### Technical Field

The present invention generally pertains to building control systems, and more particularly to wall mountable back plates for releasably securing a building control wall module to a wall of a building or other structure.

### Background

Building control systems are often used to control the operation of buildings. Building control systems can include, for example, Heating, Ventilation, and/or Air Conditioning (HVAC) systems, security systems, lighting control systems and other systems.

HVAC systems, for example, are often used to control the comfort level within a building or other structure. HVAC systems include an HVAC controller that controls various HVAC components of an HVAC system to affect and/or control one or more environmental conditions within the building. Often, the HVAC controller is mounted to a wall for convenient access. A wall mountable back plate is often first mounted to the wall, and the HVAC controller is then releasably secured to the wall mountable back plate. In some cases, control wires from HVAC components are wired to wiring terminals of the wall mountable back plate. When so provided, the wall mountable back plate often includes pin receiving terminals for receiving pins from the HVAC controller when the HVAC controller engages the wall mountable back plate. The wall mountable back plate may provide the electrical connection between the control wires for the HVAC components and the pins of the HVAC controller.

In some HVAC systems, the HVAC controller may be implemented at least in part via an Equipment Interface Module (EIM). An EIM typically receives inputs from various devices such as thermostats, sensors, other EIM's and the like, and in response, provides control signals to various HVAC components of the HVAC system. In many cases, an EIM is mounted near an HVAC component with control wires connected between the EIM and the HVAC component. A wall mountable back plate may be used to mount the EIM to the wall, and to provide the electrical connection between the control wires of the HVAC components and pins of the EIM. US2015/327375 discloses a wall plate assembly for an HVAC controller.

Other building control systems include a building controller that is mounted to a wall, sometimes via a wall mountable back plate. For example, a security system may include a security panel that is mountable to a wall via a wall mountable back plate. In another example, a lighting control system may include a lighting control panel that is mountable to a wall via a wall mountable back plate. What would be desirable is a wall mountable back plate that is eases installation and provides flexibility in wiring options.

### Summary

The present invention generally pertains to building control systems, and more particularly to wall mountable back plates for releasably securing a building control wall module to a wall of a building or other structure. According to the invention, there is provided a wall mountable back plate for releasably securing a Heating, Ventilation and/or Air Conditioning (HVAC) control module to a wall as defined in claim 1. Said wall-mountable back plate includes a housing having a front side and a back side, where the back side is configured to be mountable toward a wall. The housing defines a field wire receiving aperture through the back side of the housing that is configured to receive one or more field wires through the back side of the housing. The housing also defines a raised terminal block platform that is integrally formed with the housing and that defines a void underneath the raised terminal block platform that is accessible via the field wire receiving aperture and is available to accommodate at least part of the one or more field wires. One or more terminal blocks is/are secured to the raised terminal block platform and configured to connect one or more field wires to one or more terminals of the HVAC control module.

According to the invention, there is also provided an assembly for controlling a Heating, Ventilation and/or Air Conditioning (HVAC) system as defined in claim 11. This system includes a control module and a wall mountable back plate that is configured to releasably secure the control module relative to a wall and to provide electrical connections between the control module and the HVAC system. The control module includes a control housing having a front and a back and a plurality of terminal pins that extend from the back of the control housing. A controller is disposed within the control housing and is operably coupled to the plurality of terminal pins. The controller is configured to provide control signals to the HVAC system via the plurality of terminal pins. The wall mountable back plate includes a housing having a front side and a back side, the back side configured to be mountable toward a wall, a field wire receiving aperture through the back side of the housing and configured to receive one or more field wires and a raised terminal block platform that is integrally formed with the housing and extends over and overlaps at least a portion of the field wire receiving aperture. One or more terminal blocks are secured to the raised terminal block platform and are configured to receive stripped ends of one or more field wires and one or more of the plurality of terminal pins extending from the back of the control housing, the one or more terminal blocks configured to provide an electrical connection between the stripped ends of the one or more received field wires and corresponding ones of the received terminal pins.

The preceding summary is provided to facilitate an understanding of some of the features of the present invention and is not intended to be a full description. A full appreciation of the invention can be gained by taking the entire specification, claims, drawings, and abstract as a whole.

### Brief Description of the Drawings

The invention may be more completely understood in consideration of the following description of various illustrative embodiments of the invention in connection with the accompanying drawings, in which:
Figure 1 is a schematic view of an illustrative HVAC system servicing a building or structure;
Figure 2 is a schematic view of an illustrative HVAC control system that may facilitate access and/or control of the HVAC system of Figure 1;
Figure 3 is a perspective view of an illustrative equipment interface module (EIM) assembly that may be used in the HVAC control system of Figures 1 or 2;
Figure 4A is a front perspective view of an illustrative wall mountable back plate according to the invention usable as part of the EIM assembly of Figure 3;
Figure 4B is a rear perspective view of the illustrative wall mountable back plate of Figure 4A;
Figure 5 is a front view of an illustrative wall mountable back plate usable as part of the EIM assembly of Figure 3;
Figure 6 is a front view of an illustrative wall mountable back plate usable as part of the EIM assembly of Figure 3;
Figure 7 is a rear perspective view of an illustrative EIM usable as part of the EIM assembly of Figure 3; and
Figure 8 is a perspective view of another illustrative wall mountable back plate according to the invention.

### Description

The following description should be read with reference to the drawings wherein like reference numerals indicate like elements. The drawings, which are not necessarily to scale, are not intended to limit the scope of the invention. In some of the figures, elements not believed necessary to an understanding of relationships among illustrated components may have been omitted for clarity.

All numbers are herein assumed to be modified by the term "about", unless the content clearly dictates otherwise. The recitation of numerical ranges by endpoints includes all numbers subsumed within that range (e.g., 1 to 5 includes 1, 1.5, 2, 2.75, 3, 3.80, 4, and 5).

As used in this specification and the appended claims, the singular forms "a", "an", and "the" include the plural referents unless the content clearly dictates otherwise. As used in this specification and the appended claims, the term "or" is generally employed in its sense including "and/or" unless the content clearly dictates otherwise.

The present invention is directed generally at building automation systems. Building automation systems are systems that control one or more operations of a building. Building automation systems can include HVAC systems, security systems, fire suppression systems, energy management systems and other systems. While HVAC systems with HVAC controllers such as EIMs are used as an example below, it should be recognized that the concepts disclosed herein can be applied to building automation systems more generally.

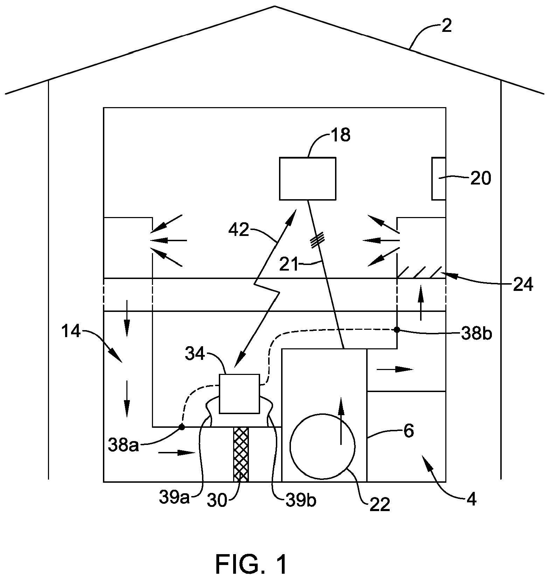

Figure 1 is a schematic view of a building 2 having an illustrative heating, ventilation, and air conditioning (HVAC) system 4. While Figure 1 shows a typical forced air type HVAC system, other types of HVAC systems are contemplated including, but not limited to, boiler systems, radiant heating systems, electric heating systems, cooling systems, heat pump systems, and/or any other suitable type of HVAC system, as desired. The illustrative HVAC system 4 of Figure 1 includes one or more HVAC components 6, a system of ductwork and air vents including a supply air duct 10 and a return air duct 14, and one or more HVAC controllers 18. The one or more HVAC components 6 may include, but are not limited to, a furnace, a boiler, a heat pump, an electric heat pump, a geothermal heat pump, an electric heating unit, an air conditioning unit, a humidifier, a dehumidifier, an air exchanger, an air cleaner, a damper, a valve, and/or the like.

It is contemplated that the HVAC controller(s) 18 may be configured to control the comfort level in the building or structure by activating and deactivating the HVAC component(s) 6 in a controlled manner. The HVAC controller(s) 18 may be configured to control the HVAC component(s) 6 via a wired or wireless communication link 20. In some cases, the HVAC controller(s) 18 may be a thermostat, such as, for example, a wall mountable thermostat, but this is not required in all embodiments. Such a thermostat may include (e.g. within the thermostat housing) or have access to one or more temperature sensor(s) for sensing ambient temperature at or near the thermostat. In some instances, the HVAC controller(s) 18 may be a zone controller, or may include multiple zone controllers each monitoring and/or controlling the comfort level within a particular zone in the building or other structure.

In the illustrative HVAC system 4 shown in Figure 1, the HVAC component(s) 6 may provide heated air (and/or cooled air) via the ductwork throughout the building 2. As illustrated, the HVAC component(s) 6 may be in fluid communication with every room and/or zone in the building 2 via the ductwork 10 and 14, but this is not required. In operation, when a heat call signal is provided by the HVAC controller(s) 18, an HVAC component 6 (e.g. forced warm air furnace) may be activated to supply heated air to one or more rooms and/or zones within the building 2 via supply air ducts 10. The heated air may be forced through supply air duct 10 by a blower or fan 22. In this example, the cooler air from each zone may be returned to the HVAC component 6 (e.g. forced warm air furnace) for heating via return air ducts 14. Similarly, when a cool call signal is provided by the HVAC controller(s) 18, an HVAC component 6 (e.g. air conditioning unit) may be activated to supply cooled air to one or more rooms and/or zones within the building or other structure via supply air ducts 10. The cooled air may be forced through supply air duct 10 by the blower or fan 22. In this example, the warmer air from each zone may be returned to the HVAC component 6 (e.g. air conditioning unit) for cooling via return air ducts 14. In some cases, the HVAC system 4 may include an internet gateway or other device 23 that may allow one or more of the HVAC components, as described herein, to communicate over a wide area network (WAN) such as, for example, the Internet.

In some cases, the system of vents or ductwork 10 and/or 14 can include one or more dampers 24 to regulate the flow of air, but this is not required. For example, one or more dampers 24 may be coupled to one or more HVAC controller(s) 18, and can be coordinated with the operation of one or more HVAC components 6. The one or more HVAC controller(s) 18 may actuate dampers 24 to an open position, a closed position, and/or a partially open position to modulate the flow of air from the one or more HVAC components to an appropriate room and/or zone in the building or other structure. The dampers 24 may be particularly useful in zoned HVAC systems, and may be used to control which zone(s) receives conditioned air from the HVAC component(s) 6.

In many instances, one or more air filters 30 may be used to remove dust and other pollutants from the air inside the building 2. In the illustrative example shown in Figure 1, the air filter(s) 30 is installed in the return air duct 14, and may filter the air prior to the air entering the HVAC component 6, but it is contemplated that any other suitable location for the air filter(s) 30 may be used. The presence of the air filter(s) 30 may not only improve the indoor air quality, but may also protect the HVAC components 6 from dust and other particulate matter that would otherwise be permitted to enter the HVAC component.

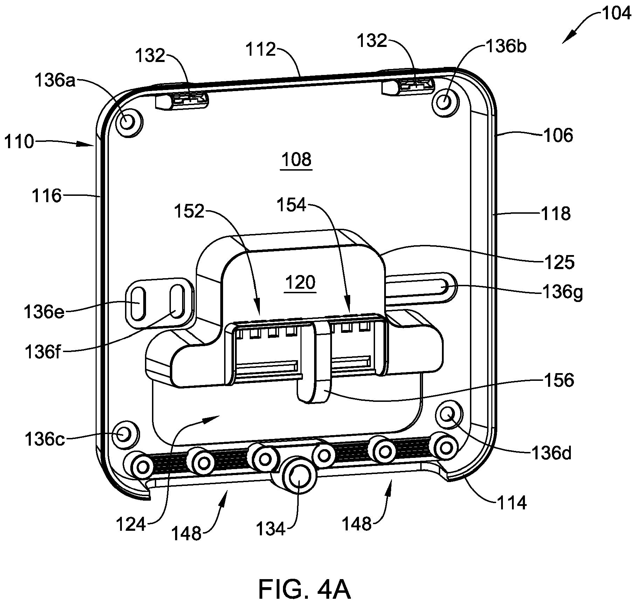

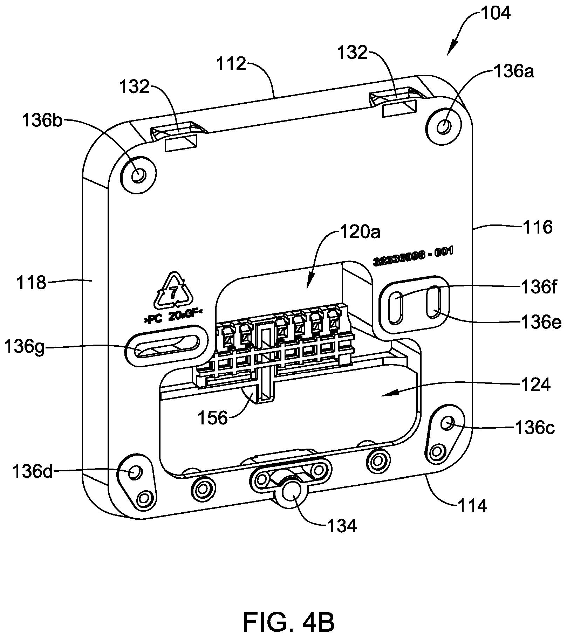

In some cases, and as shown in Figure 1, the illustrative HVAC system 4 may include an equipment interface module (EIM) 34. When provided, the equipment interface module 34 may be configured to control various HVAC components, sometimes under the direction of a an HVAC controller 18 (e.g. thermostat). In some cases, the equipment interface module 34 may receive signals from one or more sensors, and may provide appropriate control signals to one or more HVAC components of the HVAC system. An EIM typically receives inputs from various devices such as thermostats, sensors, other EIM's and the like, and in response, provides control signals to various HVAC components of the HVAC system. In many cases, the EIM is mounted near an HVAC component (e.g. near a boiler, furnace, etc.) with control wires connected between the EIM and the HVAC components to be controlled. According to the invention, a wall mountable back plate (e.g. see Figure 4) may be used to mount the EIM to a wall, and to provide the electrical connection between control wires of the HVAC components to be controlled and terminal pins extending from the EIM. When provided, the equipment interface module 34 may be configured to communicate with the HVAC controller 18 via, for example, a wired or wireless communication link 42. In other cases, the equipment interface module 34 may incorporate or be combined with the HVAC controller 18.

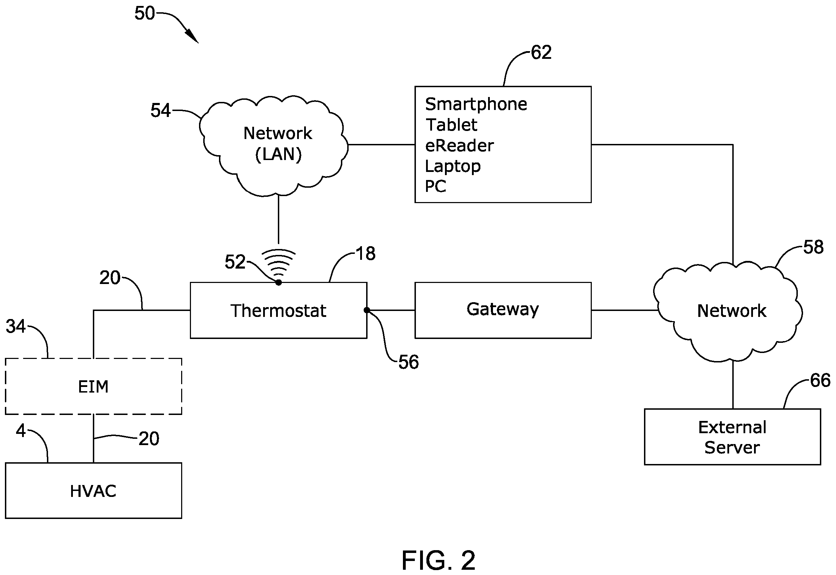

Figure 2 is a schematic view of an illustrative HVAC control system 50 that facilitates remote access and/or control of the illustrative HVAC system 4 shown in Figure 1. The HVAC control system 50 may be considered a building automation system or part of a building automation system. The illustrative HVAC control system 50 includes an HVAC controller, as for example, HVAC controller 18 and/or optionally EIM 34 that is configured to communicate with and control one or more HVAC components 6 of the HVAC system 4. As discussed above, the HVAC controller 18 and/or EIM 34 may communicate with the one or more HVAC components 6 of the HVAC system 4 via a wired or wireless communication link 20. Additionally, the HVAC controller 18 and/or EIM 34 may communicate over one or more wired or wireless networks that may accommodate remote access and/or control of the HVAC controller 18 and/or EIM 34 via another device such as a smart phone, tablet, e-reader, laptop computer, personal computer, key fob, or the like. As shown in Figure 2, the HVAC controller 18 and/or EIM 34 may include a first communications port 52 for communicating over a first network 54, and in some cases, a second communications port 56 for communicating over a second network 58. In some cases, the first network 54 may be a wireless local area network (LAN), and the second network 58 (when provided) may be a wide area network or global network (WAN) including, for example, the Internet. In some cases, the wireless local area network 54 may provide a wireless access point and/or a network host device that is separate from the HVAC controller 18 and/or EIM 34. In other cases, the wireless local area network 54 may provide a wireless access point and/or a network host device that is part of the HVAC controller 18 and/or EIM 34. In some cases, the wireless local area network 54 may include a local domain name server (DNS), but this is not required for all embodiments. In some cases, the wireless local area network 54 may be an ad-hoc wireless network, but this is not required.

In some cases, the HVAC controller 18 and/or EIM 34 may be programmed to communicate over the second network 58 with an external web service hosted by one or more external web server(s) 66. A non-limiting example of such an external web service is Honeywell's TOTAL CONNECT^{™} web service. The HVAC controller 18 and/or EIM 34 may be configured to upload selected data via the second network 58 to the external web service where it may be collected and stored on the external web server 66. In some cases, the data may be indicative of the performance of the HVAC system 4. Additionally, the HVAC controller 18 and/or EIM 34 may be configured to receive and/or download selected data, settings and/or services sometimes including software updates from the external web service over the second network 58. The data, settings, and/or services may be received automatically from the web service, downloaded periodically in accordance with a control algorithm, and/or downloaded in response to a user request. In some cases, for example, the HVAC controller 18 and/or EIM 34 may be configured to receive and/or download an HVAC operating schedule and operating parameter settings such as, for example, temperature set points, humidity set points, start times, end times, schedules, window frost protection settings, and/or the like from the web server 66 over the second network 58. In some instances, the HVAC controller 18 and/or EIM 34 may be configured to receive one or more user profiles having at least one operational parameter setting that is selected by and reflective of a user's preferences. In still other instances, the HVAC controller 18 and/or EIM 34 may be configured to receive and/or download firmware and/or hardware updates such as, for example, device drivers from the web server 66 over the second network 58. Additionally, the HVAC controller 18 and/or EIM 34 may be configured to receive local weather data, weather alerts and/or warnings, major stock index ticker data, traffic data, and/or news headlines over the second network 58. These are just some examples.

Depending upon the application and/or where the HVAC user is located, remote access and/or control of the HVAC controller 18 and/or EIM 34 may be provided over the first network 54 and/or the second network 58. A variety of remote wireless devices 62 may be used to access and/or control the HVAC controller 18 and/or EIM 34 from a remote location (e.g. remote from the HVAC Controller 18) over the first network 54 and/or second network 58 including, but not limited to, mobile phones including smart phones, tablet computers, laptop or personal computers, wireless network-enabled key fobs, e-readers, and/or the like. In many cases, the remote wireless devices 62 are configured to communicate wirelessly over the first network 54 and/or second network 58 with the HVAC controller 18 and/or EIM 34 via one or more wireless communication protocols including, but not limited to, cellular communication, ZigBee, REDLINK^{™}, Bluetooth, WiFi, IrDA, dedicated short range communication (DSRC), EnOcean, and/or any other suitable common or proprietary wireless protocol, as desired.

In some cases, an application program code (i.e. app) stored in the memory of the remote device 62 may be used to remotely access and/or control the HVAC controller 18 and/or EIM 34. The application program code (app) may be downloaded from an external web service, such as the web service hosted by the external web server 66 (e.g. Honeywell's TOTAL CONNECT^{™} web service) or another external web service (e.g. ITUNES^{®} or Google Play). In some cases, the app may provide a remote user interface for interacting with the HVAC controller 18 at the user's remote device 62. For example, through the user interface provided by the app, a user may be able to change operating parameter settings such as, for example, temperature set points, humidity set points, start times, end times, schedules, window frost protection settings, accept software updates and/or the like. Communications may be routed from the user's remote device 62 to the web server 66 and then, from the web server 66 to the HVAC controller 18 and/or EIM 34. In some cases, communications may flow in the opposite direction such as, for example, when a user interacts directly with the HVAC controller 18 and/or EIM 34 to change an operating parameter setting such as, for example, a schedule change or a set point change. The change made at the HVAC controller 18 may be routed to the web server 66 and then from the web server 66 to the remote device 62 where it may reflected by the application program executed by the remote device 62.

In some cases, a user may be able to interact with the HVAC controller 18 and/or EIM 34 via a user interface provided by one or more web pages served up by the web server 66. The user may interact with the one or more web pages using a variety of internet capable devices to effect a setting or other change at the HVAC controller 18 and/or EIM 34, and in some cases view usage data and energy consumption data related to the usage of the HVAC system 4. In some cases, communication may occur between the user's remote device 62 and the HVAC controller 18 and/or EIM 34 without being relayed through a server such as external server 66. These are just some examples.

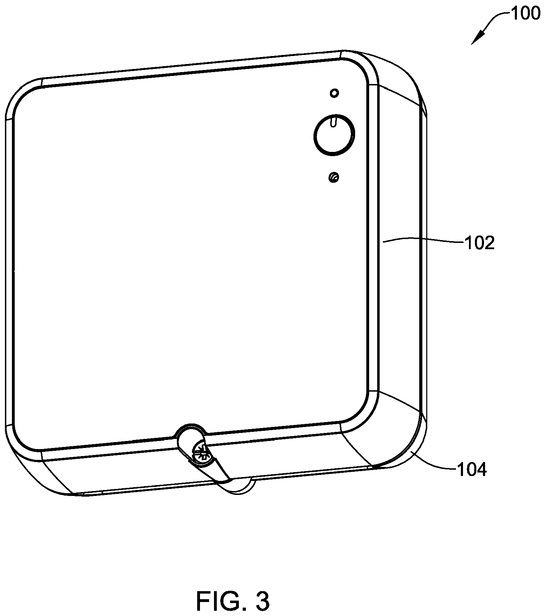

Figure 3 is a perspective view of an illustrative EIM assembly 100. The EIM assembly 100 may include an HVAC controller 18, such as a thermostat, but this is not required or even desired in some cases. In some instances, the EIM assembly 100 may be considered as an example of the equipment interface module 34 referenced in Figure 1. In some embodiments, the EIM assembly 100 may include an EIM 102 and a wall mountable back plate 104. While the assembly 100 is described as an EIM assembly, it is contemplated that similar assemblies may be used for mounting thermostats, control panels, and/or other control modules to a wall or other surface. As will be illustrated, the wall mountable back plate 104 according to the invention is configured to accommodate field wires that enter from a rear of the wall mountable back plate 104. When so provided, the wall mountable back plate 104 may provide an electrical connection between wiring terminals of the EIM 102 and field wires (not illustrated) of the HVAC system 4 (Figures 1 and 2). In the example shown, the wall mountable back plate 104 also provides a mechanical connection to the EIM 102 and may be used to secure the EIM 102 in place relative to a vertical surface such as a wall.

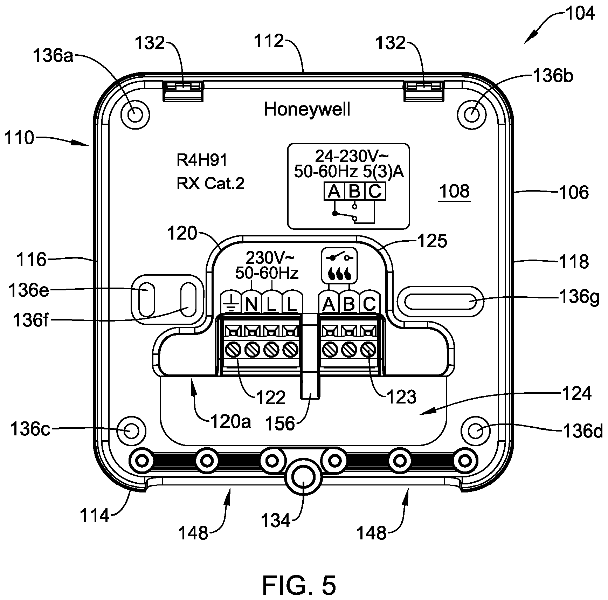

Figure 4A is a front perspective view of the illustrative wall mountable back plate 104 and Figure 4B is a rear perspective view thereof. Figure 5 is a front view of the wall mountable back plate 104 showing the inclusion of one or more terminal blocks. As shown for example in Figures 4A and 4B, the illustrative wall mountable back plate 104 has a housing 106 with a front side 108 and a back side 110. The housing 106 may have a generally square or rectangular shape, but this is not required. The back side 110 of the wall mountable back plate 104 is configured to be mounted or mountable towards a wall, or other surface. The housing 106 may further include a top edge or side 112, a bottom edge or side 114 positioned opposite from the top edge 112, a left edge or side 116, and a right edge or side 118 positioned opposite from the left edge 116. The left and right edges 116, 118 may connect the top and bottom edges 112, 114 and vice versa. The use of front, back, top, bottom, left and right are merely illustrative and are not intended to limit the structure of the housing 106 to a particular orientation. The housing 106 further defines a field wire receiving aperture 124 extending through the housing 106 from the back side 110 to the front side 108. Additionally, the field wire receiving aperture 124 may include one or more bottom openings 148 extending through the bottom edge 114 of the housing 106 in order to accommodate surface-mounted field wires that do not extend outwardly from a junction box or other wall box. The field wire receiving aperture 124 is configured to accommodate one or more field wires (not explicitly shown) extending from a wall or other surface and connected to one or more HVAC components in the building such as a boiler, fan and/or the like.

The wall mountable back plate 104 further includes a raised terminal block platform 120 configured to accommodate one or more terminal blocks. The raised terminal block platform 120 may be considered as defining a void 120a underneath the raised terminal block platform 120, the void 120a being accessible via the field wire receiving aperture 124 such that the void 120a is available to help accommodate the field wires. Alternatively, the raised terminal block platform 120 may be considered as extending over the field wire receiving aperture 124 and overlapping with at least a portion thereof such that the void 120a defines a portion of the field wire receiving aperture 124.

As shown for example in Figure 5, the raised terminal block platform 120 includes one or more terminal blocks such as a first terminal block 122 and a second terminal block 123. In some cases, there may be a single terminal block disposed on the raised terminal block platform 120. In some instances, there may be three or more distinct terminal blocks. As illustrated, the first terminal block 122 may, for example, be a higher voltage terminal block, intended for higher voltage wires, while the second terminal block 123 may be a lower voltage terminal block, intended for lower voltage wires. To illustrate, the first terminal block 122 may be configured to accommodate 230-240 volt wires while the second terminal block 123 may be configured to accommodate wires that are 48 volts or less. This is just an example. In some cases, as illustrated, the raised terminal block platform 120 may be raised relative to the front side 108. The raised terminal block platform 120 may extend about 5 millimeters (mm) to about 20 mm above the front side 108. In some cases, the raised terminal block platform 120 may extend about 10 mm to about 15 millimeters above the front side 108. These are just examples. In some instances, the raised terminal block platform 120 may span across at least a portion of the field wire receiving aperture 124, which may itself extend behind at least a portion of the raised terminal block platform 120. The raised terminal block platform 120 may extend over a majority (e.g. 50% or more) of the field wire receiving aperture 124. This is just an example. The raised terminal block platform 120 may extend over 10% or more, 25% or more, 50% or more of the field wire receiving aperture 124. In some cases, a perimeter 125 of the raised terminal block platform 120 may define at least a portion of a periphery of the field wire receiving aperture 124.

As shown in Figure 5, the raised terminal block platform 120 is configured to accommodate one or more terminal blocks such as the first terminal block 122 and the second terminal block 123. As best shown in Figure 4, the raised terminal block platform 120 may include a first terminal block receiving area 152 and a second terminal block receiving area 154, separated by a block divider 156 that extends from the housing 106. The block divider 156 may help separate and define the first terminal block receiving area 152 and the second terminal block receiving area 154 and moreover may help to physically separate higher voltage wires from lower voltage wires. In some cases, the first terminal block 122 may be held in place within the first terminal block receiving area 152 via a frictional or snap fit between the first terminal block 122 and the first terminal block receiving area 152. The second terminal block 123 may be held in place within the second terminal block receiving area 154 via a frictional or snap fit between the second terminal block 123 and the second terminal block receiving area 154, for example. In other cases, the first terminal block 122 and/or the second terminal block 123 may be attached via a screw, a clip, an adhesive, a weld, or other attachment mechanism.

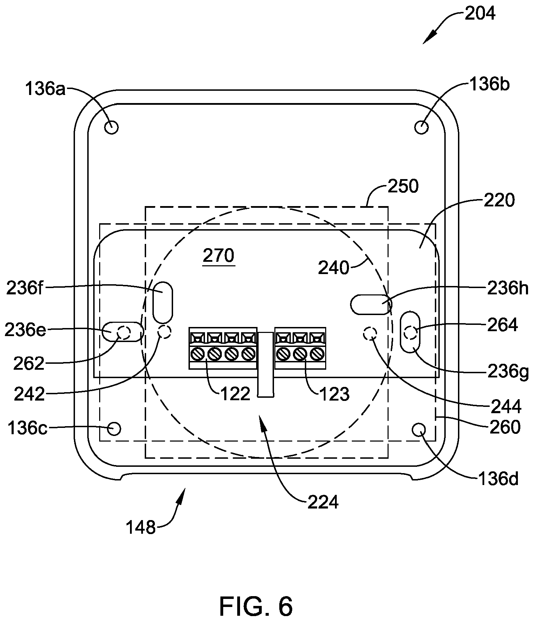

The housing 106 may include a plurality of mounting apertures 136a, 136b, 136c, 136d, 136e, 136f and 136g (collectively 136). The mounting apertures 136 may be spaced from one another and positioned such that various combinations of the mounting apertures 136 may be utilized to allow the housing 106 to be attached to a variety of different junction boxes and/or wall configurations, as will be described in more detail with respect to Figure 6. In some cases, one or more of the mounting apertures 136 may have an elongated shape to allow for more vertical and/or horizontal flexibility when aligning the mounting apertures 136 with a mating aperture in a junction box and/or mounting surface. In some cases, as illustrated, it can be seen that each of the mounting apertures 136 extend through the housing 106, from the front side 108 to the back side 110, without interfering with the raised terminal block platform 120.

To install the wall mountable back plate 104 and the EIM 102 to a wall or other mounting surface, an installer may first secure the housing 106 to the wall or mounting surface (or a junction box or other structure attached to or part of the wall). As described above, the location and size of the mounting apertures 136 used to secure the housing 106 may be strategically placed to accommodate a variety of different types or styles of junction boxes used in different countries or geographical locations. In some cases, for example if the wall mountable back plate 104 is to be mounted directly to a wall without a junction box, as may be the case if the field wires are surface mounted, the wall mountable back plate 104 may be secured to the wall by extending suitable fasteners through the mounting apertures 136a, 136b, 136c and 136d. If a junction box is to be used, the wall mountable back plate 104 is configured to be securable to a variety of different junction boxes, as shown for example in Figure 6.

Figure 6 is a front view of a wall mountable back plate 204, showing the relationship between a plurality of mounting apertures 236e, 236f, 236g, 236h (collectively mounting apertures 236) and junction boxes shown in phantom. A circular junction box 240, such as may be used for example in Germany and the Netherlands, may have an overall diameter of 72 mm and a 61 mm spacing between junction box mounting features 242 and 244. It will be appreciated that the wall mountable back plate 204 may be secured to the circular junction box 240 by placing appropriate fasteners through the mounting apertures 236f and 236h and into the junction box mounting features 242 and 244, respectively. The junction box mounting features 242 and 244 may be threaded, for example, to engage threaded fasteners.

A square junction box 250, such as may be used for example in the United Kingdom, may have a 72 mm height and 72mm width, and the same 61 mm spacing between the junction box mounting features 242 and 244, and thus the wall mountable back plate 204 may be secured to the square junction box 250 by placing appropriate fasteners through the mounting apertures 236f and 236h and into the junction box mounting features 242 and 244, respectively. A rectangular junction box 260, such as may be used for example in Italy, may have a 62 mm height and a 99 mm length, and may have an 85 mm spacing between junction box mounting features 262 and 264. The wall mountable back plate 204 may be secured to the rectangular junction box 260 by placing appropriate fasteners through the mounting apertures 236e and 236g and into the junction box mounting features 262 and 264, respectively. The junction box mounting features 262 and 264 may be threaded, for example, to engage threaded fasteners.

Figure 6 also illustrates a raised terminal block platform 220 that is larger than the raised terminal block platform 120 shown in Figures 4 and 5. In some cases, as the raised terminal block platform 220 helps to define a field wire receiving aperture 224, this may provide additional volume or space for accommodating field wires. This may be useful, for example, if there are a large number of field wires, or if some of the field wires are heavier gauge and thus stiffer and harder to bend. As will be appreciated, by making the raised terminal block platform 220 relatively larger, the mounting apertures 236 may pass through the raised terminal block platform 220. In some cases, at least some of the mounting apertures 236 are configured such that a fastener extending through one of the mounting apertures 236 engage a front surface 270 of the raised terminal block platform 220. In some instances, at least some of the mounting apertures 236 may include a molded support that extends backward from the front surface 270 of the raised terminal block platform 220, and a fastener extending therethrough would pass through a bottom of the molded support. These are just examples.

Returning briefly to Figures 4 and 5, the housing 106 may further include one or more latch mechanisms 132 configured to releasably secure the EIM 102 to the wall mountable back plate 104. The latch mechanisms 132 may be configured to cooperate with a mating latch mechanism on the EIM 102. In some instances, the EIM may be removed from the wall mountable back plate 104 through a pulling and/or rotating motion. The housing 106 may further be provided with a fixation aperture 134. The fixation aperture 134 may be configured to receive a screw, fastener, or other fixation mechanism configured to releasable secure the EIM 102 to the wall mountable back plate 104, when desired. It is contemplated that the fixation mechanism may help prevent the EIM 102 from being inadvertently detached from the wall mountable back plate 104 while still allowing for easy attachment and/removal of the EIM 102 to/from the wall mountable back plate 104. While the latch mechanisms 132 are illustrated along the top edge 112 of the housing, the latch mechanisms 132 may be positioned anywhere on the housing, including but not limited to the bottom edge 114, the left edge 116, the right edge 118, or within a central region.

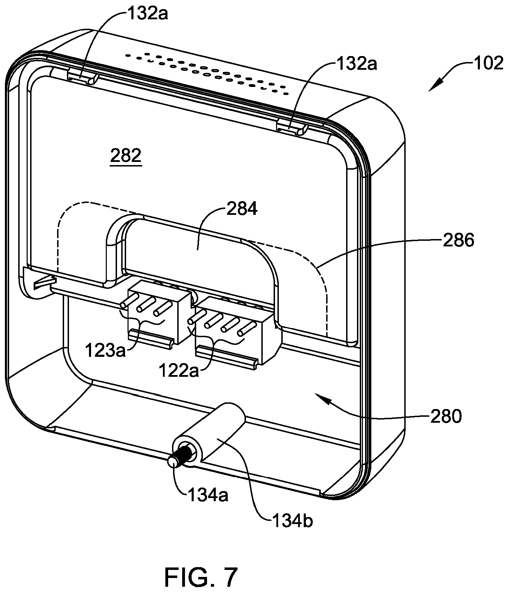

Figure 7 is a rear perspective view of the EIM 102. As can be seen, the EIM 102 includes a first set of terminal pins 122a that are positioned to engage the first terminal block 122 (Figure 5) and a second set of terminal pins 123a that are positioned to engage the second terminal block 123. A back surface 282 of the EIM 102 includes a recess 280 that may be considered as being an extension of the field wire receiving aperture 124, thereby providing additional space for accommodating field wires. The back surface 282 of the EIM 102 also includes a curved recess 284 that is configured to accommodate the profile of the raised terminal block platform 120. Shown in phantom is a corresponding recess 286 that would be appropriate for use in combination with the raised terminal block platform 220, and the wall mountable back plate 204 shown in Figure 6. It will be appreciated that the raised terminal block platform 120/220 can take any suitable shape or profile, and the back surface 282 of the EIM 102 may be configured to be complementary to that shape or profile.

The illustrative EIM 102 includes one or more clasp mechanisms 132a that are configured to engage with the corresponding latch mechanisms 132 of the wall mountable back plate 104. Once the wall mountable back plate 104 has been secured in place, the clasp mechanisms 132a may be engaged with the latch mechanisms 132 forming a hinge like structure, and the EIM 102 may be pivoted down into position. As the EIM 102 moves into position, the first set of terminal pins 122a engage the first terminal block 122 (Figure 5) and a second set of terminal pins 123a engage the second terminal block 123. A fastener 134a may be extended through a securement channel 134b that is formed within the housing of the EIM 102, and engage the fixation aperture 134 (Figures 4-5) to secure the EIM 102 in place.

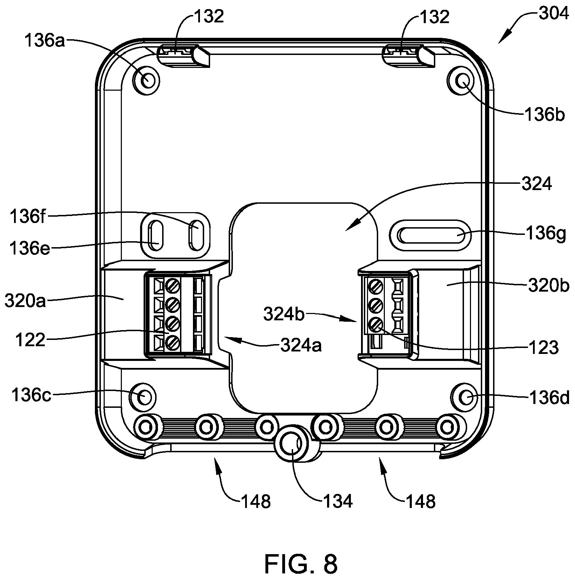

As seen in Figures 4 to 6, the raised terminal block platform 120/220 may be molded into the housing 106 and at least partially defines the field wire aperture 124/224. In some cases, the raised terminal block platform 120/220 may be divided into distinct portions. Figure 8 is a perspective view of an illustrative wall mountable back plate 304 that includes a first raised terminal block platform 320a on a first side of a field wire aperture 324 and a second raised terminal block platform 320b on a second side of the field wire aperture 324. In the example shown, the first raised terminal block platform 320a accommodates the first terminal block 122 and the second raised terminal block platform 320b accommodates the second terminal block 123. As can be seen, the first raised terminal block platform 320a defines a volume 324a that is contiguous with the field wire aperture 324. Similarly, while not visible in the illustrated orientation, the second raised terminal block platform 320b defines a volume 324b that is also contiguous with the field wire aperture 324.

## Claims

1. A wall mountable back plate (104) for releasably securing a Heating, Ventilation and/or Air Conditioning (HVAC) control module to a wall, the wall mountable back plate comprising:
a housing (106) having a front side (108) and a back side (110), the back side being configured to be mountable toward a wall;
the housing defining a field wire receiving aperture (124) through the back side of the housing, the field wire receiving aperture configured to receive one or more field wires through the back side of the housing;
**characterised in that**:
the housing defines a raised terminal block platform (120) that is integrally formed with the housing and that defines a void (120a) underneath the raised terminal block platform, the void being accessible via the field wire receiving aperture and available to accommodate at least part of the one or more field wires; and
the wall mountable back plate comprises one or more terminal blocks (122, 133) secured to the raised terminal block platform, the one or more terminal blocks being configured to connect one or more field wires to one or more terminals of the HVAC control module.

2. The wall mountable back plate of claim 1, wherein the raised terminal block platform extends over and overlaps with at least a portion of the field wire receiving aperture.

3. The wall mountable back plate of claim 2, wherein the one or more terminal blocks comprise a higher voltage terminal block and a lower voltage terminal block.

4. The wall mountable back plate of claim 3, further comprising a block divider extending up from the raised terminal block platform and separating the higher voltage terminal block from the lower voltage terminal block.

5. The wall mountable back plate of claim 1, wherein the raised terminal block platform comprises a first raised terminal block platform on a first side of the field wire receiving aperture and a second raised terminal block platform on a second side of the field wire receiving aperture, with a first terminal block disposed on the first raised terminal block platform and a second terminal block disposed on the second raised terminal block platform.

6. The wall mountable back plate of any of claims 1 to 5, wherein the housing further defines a lower field wire receiving opening configured to receive one or more field wires through a lower side of the housing.

7. The wall mountable back plate of any one of claims 1 to 6, further comprising a plurality of mounting apertures extending through the back side of the housing, the plurality of mounting apertures including a first pair of mounting apertures configured for securement to a wall box having a first spacing between wall box threaded apertures and a second pair of mounting apertures configured for securement to a wall box having a second spacing, different from the first spacing, between wall box threaded apertures.

8. The wall mountable back plate of claim 7, wherein at least some of the plurality of mounting apertures extend through the raised terminal block platform.

9. The wall mountable back plate of claim 8, wherein at least some of the plurality of mounting apertures are formed within the raised terminal block platform and pass through the field wire receiving aperture.

10. The wall mountable back plate of claim 7, wherein at least some of the plurality of mounting apertures are laterally spaced from the raised terminal block platform.

11. An assembly for controlling a Heating, Ventilation and/or Air Conditioning (HVAC) system (4), the assembly comprising:
a control module comprising:
a control housing having a front and a back;
a plurality of terminal pins (122a, 123a) extending from the back of the control housing;
a controller disposed within the control housing and operably coupled to the plurality of terminal pins, the controller being configured to provide control signals to the HVAC system via the plurality of terminal pins;
a wall mountable back plate (104) configured to releasably secure the control module relative to a wall and to provide electrical connections between the control module and the HVAC system, the wall mountable back plate comprising:
a housing (106) having a front side (108) and a back side (110), the back side being configured to be mountable toward a wall;
a field wire receiving aperture (124) through the back side of the housing and configured to receive one or more field wires;
**characterised in that**:
the wall mountable back plate comprises:
a raised terminal block platform (120) integrally formed with the housing and extending over and overlapping at least a portion of the field wire receiving aperture; and
one or more terminal block(s) (122, 123) secured to the raised terminal block platform, the one or more terminal blocks (122, 123) being configured to received stripped ends of one or more field wires and one or more of the plurality of terminal pins extending from the back of the control housing, the one or more terminal blocks being configured to provide an electrical connection between the stripped ends of the one or more received filed wires and corresponding ones of the received terminal pins.

12. The assembly of claim 11, wherein the one or more terminal blocks comprise a higher voltage terminal block and a lower voltage terminal block.

13. The assembly of any of claims 11 or 12, wherein the housing further defines a lower field wire receiving opening configured to receive one or more field wires through a lower side of the housing.

14. The assembly of any one of claims 11 to 13, further comprising a plurality of mounting apertures extending through the back side of the housing for mounting the wall mountable back plate to a plurality of different size junction boxes, where at least some of the plurality of mounting apertures are laterally spaced from the raised terminal block platform.

15. The assembly of any one of claims 11 to 14, wherein the control module is pivotably coupled to the wall mountable back plate.

## Patentansprüche

1. Eine wandmontierbare Rückplatte (104) zum lösbaren Befestigen eines Steuerungsmoduls für Heizung, Lüftung und/oder Klimatisierung (HLK) an einer Wand, wobei die wandmontierbare Rückplatte Folgendes beinhaltet:
ein Gehäuse (106), das eine vordere Seite (108) und eine rückwärtige Seite (110) aufweist, wobei die rückwärtige Seite konfiguriert ist, um zu einer Wand hin montierbar zu sein;
wobei das Gehäuse eine Feldkabelaufnahmeöffnung (124) durch die rückwärtige Seite des Gehäuses definiert, wobei die Feldkabelaufnahmeöffnung konfiguriert ist, um ein oder mehrere Feldkabel durch die rückwärtige Seite des Gehäuses aufzunehmen;
**dadurch gekennzeichnet, dass**:
das Gehäuse eine erhöhte Anschlussblockplattform (120) definiert, die mit dem Gehäuse integral gebildet ist und die einen Hohlraum (120a) unterhalb der erhöhten Anschlussblockplattform definiert, wobei der Hohlraum über die Feldkabelaufnahmeöffnung zugänglich ist und verfügbar ist, um mindestens einen Teil des einen oder der mehreren Feldkabel unterzubringen; und
die wandmontierbare Rückplatte einen oder mehrere Anschlussblöcke (122, 133) beinhaltet, die an der erhöhten Anschlussblockplattform befestigt sind, wobei der eine oder die mehreren Anschlussblöcke konfiguriert sind, um ein oder mehrere Feldkabel mit einem oder mehreren Anschlüssen des HLK-Steuerungsmoduls zu verbinden.

2. Wandmontierbare Rückplatte gemäß Anspruch 1, wobei sich die erhöhte Anschlussblockplattform über mindestens einen Abschnitt der Feldkabelaufnahmeöffnung erstreckt und damit überlappt.

3. Wandmontierbare Rückplatte gemäß Anspruch 2, wobei der eine oder die mehreren Anschlussblöcke einen Anschlussblock höherer Spannung und einen Anschlussblock niedrigerer Spannung beinhalten.

4. Wandmontierbare Rückplatte gemäß Anspruch 3, die ferner einen Blockteiler beinhaltet, der sich von der erhöhten Anschlussblockplattform nach oben erstreckt und den Anschlussblock höherer Spannung von dem Anschlussblock niedrigerer Spannung trennt.

5. Wandmontierbare Rückplatte gemäß Anspruch 1, wobei die erhöhte Anschlussblockplattform eine erste erhöhte Anschlussblockplattform auf einer ersten Seite der Feldkabelaufnahmeöffnung und eine zweite erhöhte Anschlussblockplattform auf einer zweiten Seite der Feldkabelaufnahmeöffnung beinhaltet, wobei ein erster Anschlussblock auf der ersten erhöhten Anschlussblockplattform angeordnet ist und ein zweiter Anschlussblock auf der zweiten erhöhten Anschlussblockplattform angeordnet ist.

6. Wandmontierbare Rückplatte gemäß einem der Ansprüche 1 bis 5, wobei das Gehäuse ferner einen unteren Feldkabelaufnahmedurchlass definiert, der konfiguriert ist, um ein oder mehrere Feldkabel durch eine untere Seite des Gehäuses aufzunehmen.

7. Wandmontierbare Rückplatte gemäß einem der Ansprüche 1 bis 6, die ferner eine Vielzahl von Montageöffnungen beinhaltet, welche sich durch die rückwärtige Seite des Gehäuses erstrecken, wobei die Vielzahl von Montageöffnungen ein erstes Paar Montageöffnungen, das zur Befestigung an einer Wanddose, die einen ersten Abstand zwischen Wanddosengewindeöffnungen aufweist, konfiguriert ist, und ein zweites Paar Montageöffnungen, das zur Befestigung an einer Wanddose, die einen zweiten Abstand zwischen Wanddosengewindeöffnungen aufweist, welcher sich von dem ersten Abstand unterscheidet, konfiguriert ist, umfasst.

8. Wandmontierbare Rückplatte gemäß Anspruch 7, wobei sich mindestens einige der Vielzahl von Montageöffnungen durch die erhöhte Anschlussblockplattform erstrecken.

9. Wandmontierbare Rückplatte gemäß Anspruch 8, wobei mindestens einige der Vielzahl von Montageöffnungen innerhalb der erhöhten Anschlussblockplattform gebildet sind und durch die Feldkabelaufnahmeöffnung verlaufen.

10. Wandmontierbare Rückplatte gemäß Anspruch 7, wobei mindestens einige der Vielzahl von Montageöffnungen von der erhöhten Anschlussblockplattform seitlich beabstandet sind.

11. Eine Anordnung zum Steuern eines Heizungs-, Lüftungs- und/oder Klimatisierungs-Systems (HLK-Systems) (4), wobei die Anordnung Folgendes beinhaltet:
ein Steuerungsmodul, das Folgendes beinhaltet:
ein Steuerungsgehäuse, das eine Vorderseite und eine Rückseite aufweist; eine Vielzahl von Anschlussstiften (122a, 123a), die sich von der Rückseite des Steuerungsgehäuses erstrecken;
eine Steuereinheit, die innerhalb des Steuerungsgehäuses angeordnet und betriebsfähig mit der Vielzahl von Anschlussstiften gekoppelt ist, wobei die Steuereinheit konfiguriert ist, um dem HLK-System über die Vielzahl von Anschlussstiften Steuersignale bereitzustellen;
eine wandmontierbare Rückplatte (104), die konfiguriert ist, um das Steuerungsmodul relativ zu einer Wand lösbar zu befestigen und elektrische Verbindungen zwischen dem Steuerungsmodul und dem HLK-System bereitzustellen, wobei die wandmontierbare Rückplatte Folgendes beinhaltet:
ein Gehäuse (106), das eine vordere Seite (108) und eine rückwärtige Seite (110) aufweist, wobei die rückwärtige Seite konfiguriert ist, um zu einer Wand hin montierbar zu sein;
eine Feldkabelaufnahmeöffnung (124) durch die rückwärtige Seite des Gehäuses und konfiguriert, um ein oder mehrere Feldkabel aufzunehmen;
**dadurch gekennzeichnet, dass**:
die wandmontierbare Rückplatte Folgendes beinhaltet:
eine erhöhte Anschlussblockplattform (120), die mit dem Gehäuse integral gebildet ist und sich über mindestens einen Abschnitt der Feldkabelaufnahmeöffnung erstreckt und damit überlappt; und
einen oder mehrere Anschlussblöcke (122, 123), die an der erhöhten Anschlussblockplattform befestigt sind, wobei der eine oder die mehreren Anschlussblöcke (122, 123) konfiguriert sind, um abisolierte Enden eines oder mehrerer Feldkabel und einen oder mehrere der Vielzahl von Anschlussstiften, die sich von der Rückseite des Steuerungsgehäuses erstrecken, aufzunehmen, wobei der eine oder die mehreren Anschlussblöcke konfiguriert sind, um eine elektrische Verbindung zwischen den abisolierten Enden des einen oder der mehreren aufgenommenen Feldkabel und entsprechenden Stiften der aufgenommenen Anschlussstifte bereitzustellen.

12. Anordnung gemäß Anspruch 11, wobei der eine oder die mehreren Anschlussblöcke einen Anschlussblock höherer Spannung und einen Anschlussblock niedrigerer Spannung beinhalten.

13. Anordnung gemäß einem der Ansprüche 11 oder 12, wobei das Gehäuse ferner einen unteren Feldkabelaufnahmedurchlass definiert, der konfiguriert ist, um ein oder mehrere Feldkabel durch eine untere Seite des Gehäuses aufzunehmen.

14. Anordnung gemäß einem der Ansprüche 11 bis 13, die ferner eine Vielzahl von Montageöffnungen, welche sich durch die rückwärtige Seite des Gehäuses erstrecken, zum Montieren der wandmontierbaren Rückplatte an einer Vielzahl von Verteilerdosen unterschiedlicher Größe beinhaltet, wobei mindestens einige der Vielzahl von Montageöffnungen von der erhöhten Anschlussblockplattform seitlich beabstandet sind.

15. Anordnung gemäß einem der Ansprüche 11 bis 14, wobei das Steuerungsmodul mit der wandmontierbaren Rückplatte schwenkbar gekoppelt ist.

## Revendications

1. Une plaque arrière montable sur mur (104) pour assujettir de manière libérable un module de contrôle de chauffage, ventilation et/ou climatisation (CVC) sur un mur, la plaque arrière montable sur mur comprenant :
un boîtier (106) ayant un côté avant (108) et un côté arrière (110), le côté arrière étant configuré pour être montable vers un mur ;
le boîtier définissant une ouverture de réception de câbles in-situ (124) à travers le côté arrière du boîtier, l'ouverture de réception de câbles in-situ étant configurée pour recevoir un ou plusieurs câbles in-situ à travers le côté arrière du boîtier ;
**caractérisée en ce que** :
le boîtier définit une plateforme de bloc(s) à bornes surélevée (120) qui est formée de manière solidaire avec le boîtier et qui définit une poche (120a) en dessous de la plateforme de bloc(s) à bornes surélevée, la poche étant accessible via l'ouverture de réception de câbles in-situ et disponible pour loger au moins une partie des un ou
plusieurs câbles in-situ ; et
la plaque arrière montable sur mur comprend un ou plusieurs blocs à bornes (122, 133) assujettis à la plateforme de bloc(s) à bornes surélevée, les un ou plusieurs blocs à bornes étant configurés pour raccorder un ou plusieurs câbles in-situ à une ou plusieurs bornes du module de contrôle CVC.

2. La plaque arrière montable sur mur de la revendication 1, dans laquelle la plateforme de bloc(s) à bornes surélevée s'étend par-dessus et est en chevauchement avec au moins une portion de l'ouverture de réception de câbles in-situ.

3. La plaque arrière montable sur mur de la revendication 2, dans laquelle les un ou plusieurs blocs à bornes comprennent un bloc à bornes de tension plus élevée et un bloc à bornes de tension plus basse.

4. La plaque arrière montable sur mur de la revendication 3, comprenant en sus un diviseur de blocs s'étendant vers le haut à partir de la plateforme de bloc(s) à bornes surélevée et séparant le bloc à bornes de tension plus élevée du bloc à bornes de tension plus basse.

5. La plaque arrière montable sur mur de la revendication 1, dans laquelle la plateforme de bloc(s) à bornes surélevée comprend une première plateforme de bloc(s) à bornes surélevée sur un premier côté de l'ouverture de réception de câbles in-situ et une deuxième plateforme de bloc(s) à bornes surélevée sur un deuxième côté de l'ouverture de réception de câbles in-situ, un premier bloc à bornes étant disposé sur la première plateforme de bloc(s) à bornes surélevée et un deuxième bloc à bornes étant disposé sur la deuxième plateforme de bloc(s) à bornes surélevée.

6. La plaque arrière montable sur mur de n'importe lesquelles des revendications 1 à 5, dans laquelle le boîtier définit en sus un orifice de réception de câbles in-situ inférieur configuré pour recevoir un ou plusieurs câbles in-situ à travers un côté inférieur du boîtier.

7. La plaque arrière montable sur mur de n'importe laquelle des revendications 1 à 6, comprenant en sus une pluralité d'ouvertures de montage s'étendant à travers le côté arrière du boîtier, la pluralité d'ouvertures de montage incluant une première paire d'ouvertures de montage configurées pour un assujettissement à une boîte murale ayant un premier espacement entre des ouvertures taraudées de boîte murale et une deuxième paire d'ouvertures de montage configurées pour un assujettissement à une boîte murale ayant un deuxième espacement, différent du premier espacement, entre des ouvertures taraudées de boîte murale.

8. La plaque arrière montable sur mur de la revendication 7, dans laquelle au moins certaines ouvertures de la pluralité d'ouvertures de montage s'étendent à travers la plateforme de bloc(s) à bornes surélevée.

9. La plaque arrière montable sur mur de la revendication 8, dans laquelle au moins certaines ouvertures de la pluralité d'ouvertures de montage sont formées à l'intérieur de la plateforme de bloc(s) à bornes surélevée et passent à travers l'ouverture de réception de câbles in-situ.

10. La plaque arrière montable sur mur de la revendication 7, dans laquelle au moins certaines ouvertures de la pluralité d'ouvertures de montage sont espacées latéralement de la plateforme de bloc(s) à bornes surélevée.

11. Un ensemble pour contrôler un système de chauffage, ventilation et/ou climatisation (CVC) (4), l'ensemble comprenant :
un module de contrôle comprenant :
un boîtier de contrôle ayant un avant et un arrière ;
une pluralité de broches bornes (122a, 123a) s'étendant à partir de l'arrière du boîtier de contrôle ;
un organe de contrôle disposé à l'intérieur du boîtier de contrôle et couplé de manière opérationnelle à la pluralité de broches bornes, l'organe de contrôle étant configuré pour fournir des signaux de contrôle au système CVC par le biais
de la pluralité de broches bornes ;
une plaque arrière montable sur mur (104) configurée pour assujettir de manière libérable le module de contrôle relativement à un mur et pour fournir des connexions électriques entre le module de contrôle et le système CVC, la plaque arrière montable sur mur comprenant :
un boîtier (106) ayant un côté avant (108) et un côté arrière (110), le côté arrière étant configuré pour être montable vers un mur ;
une ouverture de réception de câbles in-situ (124) à travers le côté arrière du
boîtier et configurée pour recevoir un ou plusieurs câbles in-situ ;
**caractérisé en ce que** :
la plaque arrière montable sur mur comprend :
une plateforme de bloc(s) à bornes surélevée (120) formée de manière solidaire avec le boîtier et qui s'étend par-dessus et chevauche au moins une portion de l'ouverture de réception de câbles in-situ ; et
un ou plusieurs bloc(s) à bornes (122, 123) assujettis à la plateforme de bloc(s) à bornes surélevée, les un ou plusieurs blocs à bornes (122, 123) étant configurés pour recevoir des extrémités dénudées d'un ou de plusieurs câbles in-situ et une ou plusieurs broches de la pluralité de broches bornes s'étendant à partir de l'arrière du boîtier de contrôle, les un ou plusieurs blocs à bornes étant configurés pour fournir une connexion électrique entre les extrémités dénudées des un ou plusieurs câbles in-situ reçus et des broches correspondantes des broches bornes reçues.

12. L'ensemble de la revendication 11, dans lequel les un ou plusieurs blocs à bornes comprennent un bloc à bornes de tension plus élevée et un bloc à bornes de tension plus basse.

13. L'ensemble de n'importe lesquelles des revendications 11 ou 12, dans lequel le boîtier définit en sus un orifice de réception de câbles in-situ inférieur configuré pour recevoir un ou plusieurs câbles in-situ à travers un côté inférieur du boîtier.

14. L'ensemble de n'importe laquelle des revendications 11 à 13, comprenant en sus une pluralité d'ouvertures de montage s'étendant à travers le côté arrière du boîtier pour monter la plaque arrière montable sur mur sur une pluralité de boîtes de jonction de tailles différentes, où au moins certaines ouvertures de la pluralité d'ouvertures de montage sont espacées latéralement de la plateforme de bloc(s) à bornes surélevée.

15. L'ensemble de n'importe laquelle des revendications 11 à 14, dans lequel le module de contrôle est couplé de manière à pouvoir pivoter à la plaque arrière montable sur mur.
